Europäisches Patentamt

European Patent Office

Office européen des brevets

(11) Veröffentlichungsnummer: **0 217 082**

**A1**

## (12) EUROPÄISCHE PATENTANMELDUNG

(21) Anmeldenummer: 86111165.6

(22) Anmeldetag: 12.08.86

(51) Int. Cl.⁴: **H01L 23/48**

(30) Priorität: 30.09.85 DE 3534916

(43) Veröffentlichungstag der Anmeldung:
08.04.87 Patentblatt 87/15

(84) Benannte Vertragsstaaten:
**DE FR GB NL**

(71) Anmelder: **Siemens Aktiengesellschaft Berlin
und München
Wittelsbacherplatz 2
D-8000 München 2(DE)**

(72) Erfinder: **Rusch, Helmut, Dr. rer. nat.
Schenkendorfstrasse 2
D-8400 Regensburg(DE)**
Erfinder: **Wältl, Günter, Ing. grad.
Praschweg 3
D-8400 Regensburg(DE)**
Erfinder: **Harrasser, Hansjörg, Ing. grad.
Roter Brachweg 91
D-8400 Regensburg(DE)**
Erfinder: **Richter, Hans-Jürgen, Dipl.-Ing.
Am Marktplatz 14
D-8033 Planegg(DE)**
Erfinder: **Francis, Lee
Bukit Baru
75150 Melaka West Malaysia(MY)**
Erfinder: **Seidl, Alois
Kagerer Weg 9
D-8400 Regensburg(DE)**
Erfinder: **Wissinger, Hans
Roter Brachweg 58
D-8400 Regensburg(DE)**
Erfinder: **Hampel, Hans-Joachim, Dipl.-Ing.
Friedrich-Ebert-Strasse 34
D-8400 Regensburg(DE)**

(54) **Bauelementeträger und Verfahren zur Herstellung eines Bauelements mit einem solchen Bauelementeträger.**

(57) Ein Bauelementeträger (Leadframe) für mehr als einen Halbleiterchip, bei dem pro Halbleiterchip mindestens ein elektrischer Anschluß getrennt aus einem späteren Bauelementegehäuse herausgeführt werden muß, und ein Verfahren zur Herstellung eines Bauelements mit einem solchen Bauelementeträger sollen eine volle Mechanisierung der Bauelementemontage mit guten Ausbeuten ermöglichen. Ein solcher Bauelementeträger besitzt mindestens einen Netzknoten (T1, T2, T3, T4; T), an dem durch Auftrennen eines einzigen Versteifungsknoten min-destens drei elektrische Leiter (1, 2, G; 3, 4, G; 5, 6, G; 7, 8, G; 21, 22, 23) voneinander elektrisch trennbar sind.

# FIG 1

## Bauelementeträger und Verfahren zur Herstellung eines Bauelements mit einem solchen Bauelementeträger

Die Erfindung betrifft einen Bauelementeträger nach dem Oberbegriff des Anspruchs 1 und ein Verfahren zur Herstellung eines Bauelements mit einem solchen Bauelementeträger nach dem Oberbegriff des Anspruchs 3.

Bei vielen elektrischen Bauelementen müssen mehr als eine Halbleiteranordnung auf einem Bauelementeträger montiert werden. Dabei muß mindestens ein elektrischer Anschluß pro Halbleiteranordnung getrennt aus dem das Bauelement nach Abschluß aller Montagearbeiten umhüllenden Gehäuse herausgeführt werden. Beispielsweise müssen bei LED-Leiterband-Displays pro Anzeigeelement (digit) acht diskrete Halbleiterchips auf einen Bauelementeträger montiert werden. Dabei muß mindestens ein elektrischer Anschluß pro Halbleiterchip getrennt aus dem Displaygehäuse herausgeführt werden. Dies führt zu sehr filigranen, instabilen Chipträgern.

Erschwerend bei Display-Bauelementen ist, daß die Bauelementeträger zur Montage der Display-Bauelemente U-förmig gebogen werden müssen. Dabei ergeben sich infolge der dabei notwendigen Leiterband-Konfiguration Probleme sowohl in der Ebene des Bauelementeträgers als auch in der Anschlußposition durch Auffächerung der freien Anschlüsse.

Diese Probleme führen zu Totalausfällen in der Produktion und zu Frühausfällen beim Kunden bedingt durch Drahtstreß.

Bisher hat man versucht, diese Probleme durch Aufbringen einer stabilisierenden und elektrisch isolierenden Versteifung, z.B. Kaptonfolie, auf den Bauelementeträger vor Beginn der Montage des Bauelements zu lösen.

Man hat auch versucht, diese Probleme durch Einbetten des Bauelementeträgers mit thermoplastischen oder duroplastischen Kunststoffen zu lösen. Dabei ergeben sich jedoch wiederum Probleme infolge von Kosten, infolge der mangelhaften Temperaturstabilität bei den Verarbeitungsprozessen und infolge der mangelhaften Reinheit der Bondflächen.

Man hat auch versucht, diese Probleme durch andere Trägerkonzepte , z.B. durch Verwendung einer Mini-Leiterplatte (PC-Board) anstelle eines Bauelementeträgers (Leadframe) zu lösen. Dabei ergeben sich jedoch wiederum neue Probleme infolge der hohen Kosten, die für Material und für Montage dabei anfallen.

Der vorliegenden Erfindung liegt die Aufgabe zugrunde, einen Bauelementeträger (Leadframe) der eingangs genanten Art und ein Verfahren zur Herstellung eines Bauelements mit einem solchen Bauelementeträger anzugeben, die eine volle Mechanisierung der Bauelementemontage mit guten Ausbeuten ermöglichen.

Diese Aufgabe wird durch einen Bauelementeträger nach dem Anspruch 1 und durch ein Verfahren zur Herstellung eines elektronischen Bauelements mit einem solchen Bauelementeträger nach dem Anspruch 3 gelöst.

Die Bauelementeträger werden mit netzartigen Stegen versteift. Die Herstellung der Stege kann vorteilhaft und kostenneutral beim Stanzen des Bauelementeträgers erfolgen. Dadurch erhält man ein in sich stabiles Leadframe.

Die in der Beschreibungseinleitung angegebenen Probleme beim Stand der Technik können bei keinem einzigen Arbeitsgang zur Herstellung eines Bauelements mit einem Bauelementeträger nach der Erfindung mehr auftreten. Damit ist eine volle Mechanisierung der Bauelementemontage mit einem Bauelementeträger nach der Erfindung mit guten Ausbeuten möglich. Nach Abschluß aller Montageschritte, die zur Herstellung eines Bauelements mit einem Bauelementeträger nach der Erfindung erforderlich sind, kann die Auftrennung der Netzknoten erfolgen. Die Auftrennung dieser Netzknoten kann jedoch auch schon nach einem Montageschritt erfolgen, bei den der Träger bereits so stabilisiert ist, daß keine Ausfälle und qualitätsmindernden Einflüsse mehr auftreten können. Ein solcher Arbeitsgang ist üblicherweise die Umhüllung bzw. die Fixierung der auf dem Bauelementeträger angeordneten Halbleiterchips.

Die Auftrennung der Netzknoten kann vorteilhaft nach folgenden Verfahren erfolgen:

Die Netzknoten können durch Bohren aufgetrennt werden. Dieses Bohren zum Auftrennen der Netzknoten kann analog zu demjenigen Bohren erfolgen, wie es bei der Leiterplattenfertigung angewandt wird.

Die Netzknoten können durch elektrischen Hochstromimpuls getrennt werden.

Die Netzknoten können mittels Laserstrahlung getrennt werden.

Die Netzknoten können mittels Ultraschallbeaufschlagung getrennt werden.

Die Netzknoten können mechanisch, z.B. durch Stanzen, Schneiden, usw. getrennt werden.

Die Netzknoten können chemisch, z.B. durch selektives Ätzen, getrennt werden.

Die Erfindung wird im folgenden anhand der Zeichnung erläutert.

Fig. 1 zeigt einen Display-Bauelementeträger mit internen Versteifungen.

Fig. 2 erläutert den Begriff des Netzknotens.

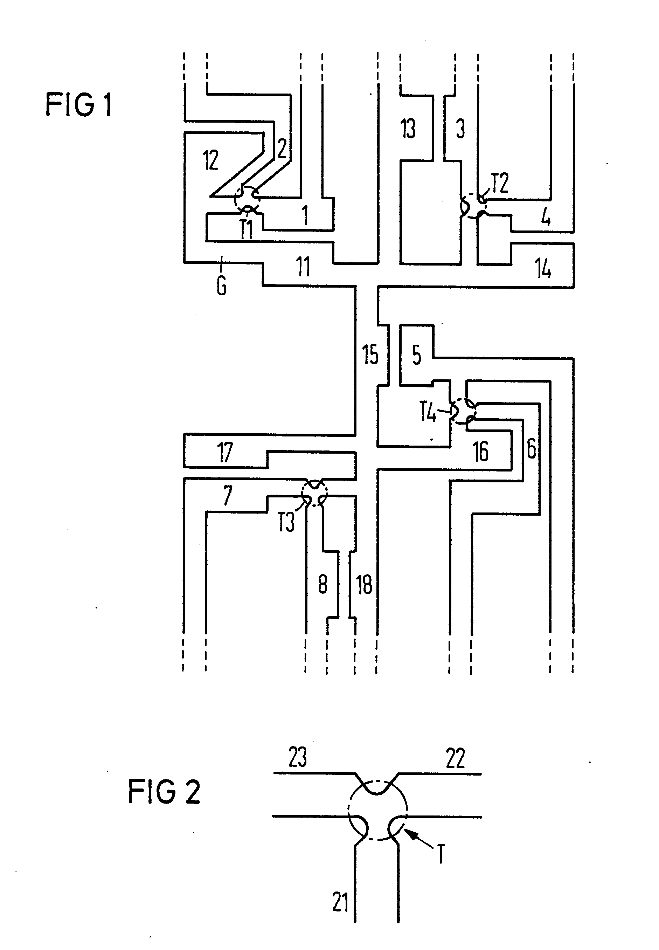

Fig. 1 zeigt einen Display-Bauelementeträger mit internen Versteifungen (metal bar) T1, T2, T3, T4. In Fig. 1 ist derjenige Bereich eines Bauelementeträgers mit durchgezogenen Linien dargestellt, der für ein einziges Anzeigeelement (digit) dient. Der Bauelementeträger der Fig. 1 kann einstückig für weitere Anzeigeelemente eines LED-Leiterband-Display-Bauelements nach mehreren Seiten hin fortgesetzt werden. Solche möglichen einstückigen Fortsetzungen des Bauelementeträgers sind in Fig. 1 punktiert angedeutet.

Auf dem mit durchgezogenen Linien in Fig. 1 angegebenen Stück des Bauelementeträgers kann ein Anzeigeelement (digit) mit acht diskreten Halbleiterchips montiert werden. Acht elektrische Anschlüsse 1 bis 8, für jeden Halbleiterchip also ein extra elektrischer Anschluß, müssen getrennt aus dem später zu erstellenden Bauelemetegehäuse, das die acht diskreten Halbleiterchips des Anzeigeelements (digit) umhüllen wird, getrennt herausgeführt werden. Diese acht elektrischen Anschlüsse 1 bis 8 dienen zur elektrischen Ansteuerung der acht diskreten Halbleiterchips des Anzeigeelements (digit).

Alle acht diskreten Halbleiterchips können über die Masseleitung G an das Massepotential angeschlossen werden. Zu diesem Zweck besitzt die Masseleitung G acht Kontaktflecken 11 bis 18.

Der Bauelementeträger von Fig. 1 ist mit netzartigen Stegen T1, T2, T3, T4 versteift. Die Herstellung dieser Stege T1, T2, T3, T4 erfolgt kostenneutral beim Stanzen des Bauelementeträgers. Dadurch bildet der Bauelementeträger ein in sich stabiles Leadframe. An den Netzknoten T1, T2, T3, T4 sind jeweils 3 elektrische Leiter einstückig miteinander verbunden, nämlich am Netzknoten T1 die elektrischen Leiter 1, 2, G, am Netzknotzen T2 die elektrischen Leiter 3, 4, G, am Netzknoten T3 die elektrischen Leiter 7, 8, G und am Netzknoten T4 die elektrischen Leiter 5, 6, G.

Der Bauelementeträger nach Fig. 1 ermöglicht infolge seiner Netzknotzen T1, T2, T3, T4 eine volle Mechanisierung der Bauelementemontage mit guten Ausbeuten. Nach Abschluß aller Montageschritte erfolgt die Auftrennung der Netzknoten T1, T2, T3, T4. Dabei ist es von besonderem Vorteil, daß durch Auftrennen eines jeweils einzigen Netznotens gleichzeitig jeweils 3 zuvor einstückig miteinander verbundene elektrische Leiter schließlich voneinander elektrisch isoliert sind. Ebenso ist es von besonderem Vorteil, daß durch Anbringen einer relativ geringen Zahl von internen Versteifungen - (T1, T2, T3, T4) eine hohe Stabilität des Bauelementeträgers (Leadframe) erzielt wird.

Nach Abschluß aller Montageschritte ist bei der dann erfolgenden Auftrennung der Netzknoten T1, T2,T3, T4 auf grund der dann bereits erfolgten endgültigen Umhüllung bzw. Fixierung der Halbleiterchips bezüglich der elektrischen Leiter der Bauelementeträger bereits so stabilisiert, daß keine Ausfälle und qualitätsmindernden Einflüsse mehr auftreten können.

Fig. 2 erläutert den Begriff des Netzknotens T. Am Netzknoten T stoßen die 3 elektrischen Leiter 21, 22, 23 zusammen. An diesem Netzknoten T sind die 3 elektrischen Leiter 21, 22, 23 einstückig ausgebildet. Der Versteifungs-Knoten des Netzknotens-T hat vorteilhafterweise eine solche Flächenausdehnung, daß er mit möglichst geringem Aufwand möglichst rasch aufgetrennt werden kann und daß er andererseits eine ausreichende Stabilität des Bauelementeträgers während der Montage des Bauelements gewährleistet. Vorteilhafterweise weist der Netzknoten T zu diesem Zweck Einschnürungen auf, die ein sicheres Auftrennen des Netzknotens T ermöglichen.

Die Halbleiterchips können auf dem Bauelementeträger vergossen, gekapselt oder sonstwie fixiert werden. Der Montage-Bauelementeträger - (Leadframe), kann aus einem geeigneten Metallstreifen (Cu, Fe, Messing, Neusilber usw.) ausgestanzt oder ausgeätzt werden. Dieser Metallstreifen kann je nachden speziellen Anforderungen eine beliebige Dicke und eine beliebige Breite haben. Insbesondere kann ein solcher Metallstreifen etwa 0,25 mm dick und etwa 2,5 cm breit sein. Die elektrischen Leiter können auch jeweils den speziellen Anforderungen entsprechend breit ausgebildet sein. Insbesondere können die internen Versteifungen (Netzknoten) an ihrer engsten Stelle eine lineare Abmessung von etwa 0,2 mm besitzen. Ein erfindungsgemäßer Bauelementeträger kann aus Platzgründen zusätzlich auch Versteifungsknoten aufweisen, nach deren Auftrennung nur zwei elektrische Leiter voneinander getrennt sind.

Bezugszeichenliste

T1 interne Versteifung
T2 interne Versteifung
T3 interne Versteifung
T4 interne Versteifung
G elektrischer Leiter
1 -8 elektrische Anschlüsse
11 -18 Kontaktflecken
T Netzknoten
21 elektrischer Leiter

22 elektrischer Leiter
23 elektrischer Leiter

## Ansprüche

1. Bauelementeträger (Leadframe) für mehr als einen Halbleiterchip, bei dem pro Halbleiterchip mindestens ein elektrischer Anschluß getrennt aus einem späteren Bauelementegehäuse herausgeführt werden muß, gekennzeichnet durch mindestens einen Netzknoten (T1, T2, T3, T4 ;T), an dem durch Auftrennen eines einzigen Versteifungsknoten mindestens drei elekrische Leiter (1, 2, G; 3, 4, G; 5, 6, G; 7, 8, G; 21, 22, 23) voneinander elektrisch trennbar sind.

2. Bauelement nach Anspruch 1 für 8 diskrete Halbleiterchips eines LED-Leiterband-Display-Anzeigeelements (digit), gekennzeichnet durch 4 Netzknoten (T1, T2, T3, T4), an denen jeweils durch Auftrennen eines einzigen Versteifungsknotens 3 elektrische Leiter (1, 2, G; 3, 4, G; 5, 6, G; 7, 8, G) voneinander elektrisch trennbar sind.

3. Verfahren zur Herstellung eines elektrischen Bauelements mit einem Bauelementeträger (Leadframe) für mehr als einen Halbleiterchip, bei dem pro Halbleiterchip mindestens ein elektrischer Anschluß getrennt aus einem Bauelementegehäuse herausgeführt wird, dadurch gekennzeichnet, daß der Bauelementeträger mit mindestens einem Netznoten (T1, T2, T3, T4; T) versteift wird, an dem nach erfolgter Stabilisierung des Bauelementeträgers durch Fixieren des mindestens einen Halbleiterchips bezüglich des Bauelementeträgers jeweils durch Auftrennen eines einzigen Versteifungsknotens mindestens drei elekrische Leiter (1, 2, G; 3, 4, G; 5, 6, G; 7, 8, G; 21, 22, 23) voneinander elekrisch getrennt werden.

4. Verfahren nach Anspruch 3, dadurch gekennzeichnet, daß die Herstellung des mindestens einen Netzknotens (T1, T2, T3, T4; T) beim Stanzen des Bauelementeträgers erfolgt.

5. Verfahren nach Anspruch 3 oder 4, dadurch gekennzeichnet, daß das Auftrennen des mindestens einen Netzknotens (T1, T2, T3, T4; T) durch Bohren erfolgt.

6. Verfahren nach Anspruch 3 oder 4, dadurch gekennzeichnet, daß das Auftrennen des mindestens einen Netzknotens (T1, T2, T3, T4; T) durch elektrischen Hochstromimpuls erfolgt.

7. Verfahren nach Anspruch 3 oder 4, dadurch gekennzeichnet, daß das Auftrennen des mindestens einen Netzknotens (T1, T2, T3, T4; T) mittels Laserstrahlung erfolgt.

8. Verfahren nach Anspruch 3 oder 4, dadurch gekennzeichnet, daß das Auftrennen des mindestens einen Netzknotens (T1, T2, T3, T4; T) mittels Ultraschall erfolgt.

2. Verfahren nach Anspruch 3 oder 4, dadurch gekennzeichnet, daß das Auftrennen des mindestens einen Netzknotens (T1, T2, T3, T4; T) mechanisch vorgenommen wird.

10. Verfahren nach Anspruch 3 oder 4, dadurch gekennzeichnet, daß das Auftrennen des mindestens einen Netzknotens (T1, T2, T3, T4; T) chemisch erfolgt.

FIG 1

FIG 2

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| Y | GB-A-2 103 418 (S. BRACEY) <br> * Seite 5, Zeilen 13-29; Figur 2 * | 1-10 | H 01 L 23/48 |
| Y | EP-A-0 092 930 (AMP INC.) <br> * Ansprüche; Figur 3 * | 1,2 | |
| Y | EP-A-0 066 836 (SIEMENS) <br> * Ansprüche * | 3-10 | |
| A | EP-A-0 059 092 (T. ANGELUCCI) <br> * Zusammenfassung; Figur 3 * | 1-5,9 | |
| A | US-A-3 691 290 (J. NAPIER) <br> * Ansprüche; Figur 1 * | 1-5 | |
| A | US-A-4 331 740 (C. BURNS) <br> * Ansprüche * | 1-5 | RECHERCHIERTE SACHGEBIETE (Int. Cl.4) <br><br> H 01 L |
| A | PATENTS ABSTRACTS OF JAPAN, Band 7, Nr. 144 (E-183)[1289], 23. Juni 1983; JP-A-58 56 360 (SUMITOMO KINZOKU KOUZAN K.K.) 04-04-1983 | 1-5,9 | |
| A | EP-A-0 063 408 (AMP INC.) <br> * Zusammenfassung; Figur 7 * | 1-5 | |

Der vorliegende Recherchenbericht wurde für alle Patentansprüche erstellt.

| Recherchenort | Abschlußdatum der Recherche | Prüfer |
|---|---|---|
| DEN HAAG | 03-10-1986 | GALLO G. |